# EUROPEAN PATENT SPECIFICATION

(11) **EP 4 568 148 B1**
(45) Date of publication and mention of the grant of the patent: **12.08.2026**
(21) Application number: 23214841.1
(22) Date of filing: 07.12.2023
(51) Int. Cl.: H04L 1/00, H03M 13/23, H03M 13/00

(54) **METHOD, RECEIVER AND SYSTEM FOR FAST DECODING OF A WIRELESS TRANSMISSION COMPRISING MULTIPLE PACKETS**
VERFAHREN, EMPFÄNGER UND SYSTEM ZUR SCHNELLEN DECODIERUNG EINER DRAHTLOSEN ÜBERTRAGUNG MIT MEHREREN PAKETEN
PROCÉDÉ, RÉCEPTEUR ET SYSTÈME DE DÉCODAGE RAPIDE D'UNE TRANSMISSION SANS FIL COMPRENANT DE MULTIPLES PAQUETS

(43) Date of publication of application: 11.06.2025
(73) Proprietor: Kamstrup A/S, 8660 Skanderborg (DK)
(72) Inventor: Toft, Jesper Torsvik, 8660 Skanderborg (DK); Birklykke, Alex, 8660 Skanderborg (DK); Hald, Flemming, 8660 Skanderborg (DK)
(74) Representative: Patentanwälte Hemmer Lindfeld Frese Partnerschaft mbB

(56) References cited:
- EP-A1- 2 924 907
- WO-A1-2016/161843
- US-A1- 2020 287 660

## Description

The present invention is directed to a method for fast decoding of a wireless transmission comprising multiple packets to obtain a payload comprising a plurality of payload bits at a receiver. The invention is further directed to a receiver configured to perform a method for fast decoding of a wireless transmission as well as a system comprising a transmitter configured for transmitting a wireless transmission comprising multiple packets as well as a receiver configured for fast decoding of the wireless transmission.

Smart utility meters such as smart water meters, smart heat meters, smart gas meters or smart electricity meters oftentimes use low-power wide area networks (LPWAN) for radio transmissions of measurement data to a central receiver or base station. The radio transmissions may in some embodiments be unidirectional in which case the smart meter transmitting the data over the LPWAN does not have a back channel for receiving communications from the receiver. This precludes amongst others the transmission of feedback from the receiver. Hence, the base station can neither confirm the successful receipt of a packet nor request the retransmission of a missing data packet or an unsuccessfully transmitted data packet. In other embodiments, the radio transmission may be bidirectional also allowing communications from the base station to the smart meter.

Base stations for smart meters commonly receive transmission from many smart meters. Each of the smart meters transmits data packets independently without knowledge of the remaining transmitters paired with the same base station. Also, other third-parties use the same frequencies that are used for LPWAN protocols since the use of the frequencies is not exclusive. Interference is thus a severe problem at base station where packets from different smart meters and transmissions from other parties may collide. One way of tackling interference at the base station is to shorten the time each radio transmission takes, i.e., the on-air time of the transmitters. The longer a transmission occupies the medium in a congested environment, the greater the probability that a packet will collide with other packets. Therefore, reducing the on-air time is an effective strategy for combating interference.

Shortening the on-air time has further benefits for battery-powered smart meters. Due to strict lifetime requirements of between 10 years to 20 years, the maximum current that can be drawn from the battery of a smart meter is typically much less than what is required for a transmission. Hence, some form of energy buffer such as a high-quality capacitor or super capacitor is required to enable transmissions. As the size or capacity of the energy buffer increases with on-air time, so does the cost of the energy buffer. Hence, the on-air time is also a driver for costs of the smart meters. Consequently, a short on-air time is an important design parameter for LPWAN protocols as it effects both the costs of the smart meters as well as congestion at the base station.

The on-air time can be reduced in various ways, for example, by increasing the symbol rate, optimizing the frame structure, limiting the packet size, or fragmenting the payload. For example, the on-air time can be effectively reduced by employing multi-burst transmissions with incremental redundancy as disclosed, for example, in EP 2 924 907 A1. Here, each payload is encoded at the transmitter using forward error correction and then transmitted in multiple packets. Each packet comprises a subset of the encoded payload. The subsets are chosen so that it is possible to recover the unencoded payload at the receiver from each individual packet using a forward error correction algorithm such as Viterbi or Turbo decoding. When the decoding of individual packets of a multi-packet or multi-burst transmission fails, two or more packets from the multi-burst transmission can be combined to increase the coding gain, provided that the induvial subsets are at least partially mutually exclusive. The more packets from a multi-burst transmission are combined, the higher the coding gain. Hence, the name incremental redundancy.

According to EP 2 924 907 A1, a packet identification number needs to be included in the header of each packet to identify the subset of encoded bits included in the respective packet. This allows decoding the packet using forward error correction or combing the respective packet with other packets. However, including a packet identification number has the downside of increasing the on-air time as additional control information in form of the packet identification number needs to be transmitted with every packet. Furthermore, decoding every received packet using forward error correction is computationally expensive which is a particular problem at base stations which are paired with many smart meters and, therefore, receive large numbers of packets in parallel.

The patent document US2020287660A1 discloses convolutional encoding and packet-specific puncturing patterns, each pattern selecting respective subsets of encoded bits.

Hence, in view of the above it can be considered an object of the present invention to provide an improved method, receiver, and system capable of fast decoding of wireless transmissions comprising multiple packets.

The problem is solved by a method for fast decoding of a wireless transmission comprising multiple packets, a receiver implementing the method as well as a system comprising a transmitter and a corresponding receiver according to the respective independent claims. Preferred embodiments of the method and the system are the subject matter of the dependent claims.

In a first aspect the problem underlying the present invention is solved by a method for fast decoding of a wireless transmission comprising multiple packets to obtain a payload comprising a plurality of payload bits at a receiver. Each packet of the multiple packets comprises a subset of a plurality of encoder output bits. The plurality of encoder output bits was obtained at a transmitter by encoding the payload bits with a plurality of convolutional encoders with different polynomials. The subset for each packet was selected according to a packet-specific puncturing pattern from the plurality of encoder output bits. The packet-specific puncturing pattern is selected at the transmitter from a set of predetermined packet-specific puncturing patterns. Each subset of the plurality of encoder output bits selected for a packet of the multiple packets allows decoding the entire payload. The method includes receiving a packet of the multiple packets at the receiver comprising a plurality of received encoder output bits. A packet-specific puncturing pattern is selected from the set of predetermined packet-specific puncturing patterns. Based on the selected packet-specific puncturing pattern, for each received encoder output bit in the received packet the convolutional encoder that would have been used to obtain the respective encoder output bit according to the selected packet-specific puncturing pattern is determined and an inverse of the determined convolutional encoder is used to decode the respective encoder output bit to obtain the corresponding payload bit. After decoding all received encoder output bits of the received packet, an integrity check of the obtained payload bits is performed to determine whether the packet was received error free and whether the selected packet-specific puncturing pattern was used at the transmitter to select the encoder output bits for the received packet.

In other words, the present invention provides a fast method for retrieving a payload that has been transmitted in multiple packets as part of a multi-burst transmission. It is primarily intended to be used for retrieving payloads wirelessly transmitted by smart meters via a LPWAN to a central base station. The LPWAN may allow unidirectional or bidirectional communication between the transmitter and the receiver. The aim of the decoding scheme employed at the receiver is to reduce the computational load caused by the decoding of the packets by offering a lightweight decoding of multi-burst protocols. Furthermore, decoding advantageously avoids the use of time-consuming and resource heavy forward error correction decoding where a message was received error-free. Thus, for error-free packets the computational load of the receiver and also the time required for decoding packets is considerably reduced.

The packets to be decoded at the receiver are part of multi-packet or multi-burst transmission carrying a single payload. The payload comprises a plurality of payload bits that are encoded at the transmitter for forward error correction. For encoding the payload bits, the transmitter comprises multiple convolutional encoders with different polynomials. For example, a transmitter may comprise L different convolutional encoders for encoding a payload of M payload bits which results in *L*·*M* encoded bits or encoder output bits.

Each of the L different convolutional encoders employs a different polynomial for encoding the same payload, i.e., each of the convolutional encoders uses a different encoder transfer function H(z). The polynomial of one convolutional encoder of the multiple convolutional encoders may also be the unity function, i.e., *H*(*z*) = 1. A convolutional encoder with a unity transfer function does not encode payload bits for forward error correction. Therefore, the encoder output bits of this specific encoder correspond to the payload bits.

For each packet of the multiple packets that are transmitted by the transmitter, a subset of the encoder output bits is selected according to a packet-specific puncturing pattern. The packet-specific puncturing patterns could also be referred to as selection patterns and define for each packet of the multi-burst transmission which output bits are selected from which of the convolutional encoders to be transmitted as part of which packet. For example, if the wireless transmission comprises N packets, there are N different packet-specific puncturing patterns for selecting N subsets *S*₁, *S*₂, ..., *S_{N}* of encoder output bits, one for each packet. The puncturing patterns are packet-specific in that there is one specific puncturing pattern for each packet of the multiple packets, i.e., there is a first packet-specific puncturing pattern for the first packet, a second packet-specific puncturing pattern for the second packet, and so on. Together the N packet-specific puncturing patterns form a set of predetermined packet-specific puncturing patterns.

The encoder output bits for each of the packets are selected so that initial payload can be reconstructed from each of the packets without needing additional information carried in any of the other packets. Each packet comprises at least one encoder output bit for each unencoded payload bit. Hence, each packet comprises at least M encoder output bits for a payload with M payload bits. Since the payload can be retrieved from each packet individually, combining packets is only necessary in case decoding of all individual packets fails.

A packet may comprise further bits in addition to those selected according to the specific packet puncturing pattern. In an exemplary embodiment, each packet additionally comprises at least one of synchronization bits and header bits.

According to the method, at least one packet of the multiple packets is received at a receiver. The receiver may, for example, be a base station or gateway for an LPWAN. The packet comprises a plurality of received encoder output bits and may further comprise additional bits such as synchronization bits and header bits.

Having received at least one packet of the multiple packets, the receiver selects or picks one packet-specific puncturing pattern from the set of predetermined packet-specific puncturing patterns. When picking the puncturing pattern, the receiver does not know which packets of the multiple packets has been received at the receiver. The receiver thus has to guess or make an assumption which of the N packets has been received. Hence, different strategies can be used to select a selection or puncturing pattern. In an exemplary preferred embodiment, the receiver always starts with the packet-specific puncturing pattern used at the transmitter for selecting the encoder output bits for the first packet. This will usually be the optimal choice. Alternatively, a receiver could take into consideration that one or more other packets of the multiple packets have been already received that may have been transmitted by the same transmitter and so the receiver may choose to pick a packet-specific puncturing pattern used for selecting the subset of bits for a subsequent packet.

Having selected a packet-specific puncturing pattern, the receiver then tries to decode the received packet. To this end, the receiver makes use of the fact that a convolutional encoder can be seen as a binary linear time invariant system. The transfer functions of the convolutional encoders can thus be inverted, and the received encoder output bits can be propagated backwards through the convolutional encoder to retrieve the payload provided that the packet was received error free.

In more detail, a convolutional encoder may have an encoder transfer function H(z) = *g*₀(*z*)/*g*₁(*z*), where *g*₀(*z*) and *g*₁(*z*) are the feed-forward and feed-backward polynomials. The inverse of the convolutional encoder can be obtained by multiplicatively inverting the transfer function to obtain the inverse encoder transfer function *H*⁻¹(*z*) = *g*₁(*z*)/*g*₀(*z*). The convolutional encoder with the encoder transfer function *H*⁻¹(*z*) will subsequently also be referred to as the inverse convolutional encoder to the convolutional encoder with the encoder transfer function H(z). For example, if the transmitter has L convolutional encoders, there are also L corresponding inverse convolutional encoders at the receiver.

After receiving a packet and picking a puncturing pattern potentially used to select the encoder output bits for the packet, the receiver decodes the received encoder output bits using the L inverse convolutional encoders to obtain the original payload bits. The puncturing pattern indicates to the receiver which inverse convolutional encoder has to be used to decode which received encoder output bit assuming that the correct puncturing bit was used. Thus, provided that the packet was received error free and that the correct packet-specific puncturing pattern has been selected, the original payload can advantageously be retrieved from a single packet by propagating the received encoder output bits through the inverse convolutional encoders without having to perform computationally expensive forward error correction such as Viterbi or Turbo decoding.

Finally, after decoding all received encoder output bits using the inverse convolutional encoder, the receiver performs an integrity check of the obtained payload bits. Using the integrity check it can be confirmed whether the correct packet-specific puncturing pattern has been selected and whether the received packet was error-free. The integrity check may be made using error-detecting codes such as, for example, a cyclic redundancy check (CRC). To this end, one or more integrity check bits may have to be included into the payload.

Thus, the method for fast decoding according to the present invention advantageously provides a fast way of determining a payload that was transmitted using a multi-packet or multi-burst transmissions. As compared to the prior art, the invention advantageously reduces the computational effort required for decoding a packet as an error-free received packet is decoded using an inverse convolutional encoder and forward error correction is avoided. Furthermore, the method also allows decoding packets without a packet identifier in the packet header as the packet-specific puncturing pattern is inferred and does not have to be transmitted. Thus, the on-air time required for each transmission can be reduced which results in fewer collisions due to less congestion of the medium at the receiver. Also, by reducing the on-air time of the transmitter, less transmission power is used which is always beneficial for battery-powered devices such as many smart meters.

In a preferred embodiment, in case the integrity check fails, an other packet-specific puncturing pattern is selected from the set of predetermined packet-specific puncturing patterns. Based on the other packet-specific puncturing pattern, for each received encoder output bit in the received packet the convolutional encoder used to obtain the respective encoder output bit is determined and an inverse of the determined convolutional encoder is used to decode the respective encoder output bit to obtain the corresponding payload bit. After decoding all received encoder output bits of the received packet using the other packet-specific puncturing pattern, an integrity check of the obtained payload bits is performed to determine whether the packet was received error free and whether the other packet-specific puncturing pattern was used at the transmitter to select the encoder output bits for the received packet.

Hence, the preferred embodiment of the method is carried out in case the final check of the first try to decode a packet shows that the packet was not received error free and/or that the wrong puncturing pattern had been chosen. Assuming that the wrong puncturing pattern had been chosen, the receiver picks another patent-specific puncturing pattern and then tries decoding the received packet in the already described manner using the inverse convolutional encoders.

Various strategies exist for selecting the other packet-specific puncturing pattern. For example, the puncturing pattern can be chosen randomly from the set of predetermined packet-specific puncturing patterns excluding any puncturing pattern that has already been tried on this packet. In another example, if the previously used puncturing pattern is used for a packet n at the transmitter, the next puncturing pattern that is used could be the puncturing pattern that is used for selecting the encoder output bits for the packet *n*+*1* at the transmitter.

After decoding all received encoder output bits using the second selected puncturing pattern, again an integrity check is performed to determine whether the second puncturing pattern was puncturing pattern was the correct puncturing pattern and whether the received packet was error free. If the check is passed, the payload is advantageously obtained without having to perform forward error correction. This advantageously saves computational resources at the receiver.

If the CRC check fails again, the method may continue to cycle through the remaining packet-specific puncturing patterns until the integrity check on the obtained payload bits is successful. Different strategies may be applied. The method may cycle through all packet-specific puncturing patterns in the set of predetermined packet-specific puncturing patterns or only selected packet-specific puncturing patterns before turning to other packets or taking other steps.

In a preferred embodiment, in case the integrity check fails for at least one and preferably all packet-specific puncturing patterns in the set of predetermined packet-specific puncturing patterns for the received packet, the method involves trying to decode the received packet using forward error correction.

Preferably, in case the integrity check fails for all packet-specific puncturing patterns in the set of predetermined packet-specific patterns for two or more packets of the multiple packets received at the receiver, combine at least two of the packets of the multiple packets received at the receiver for forward error correction. Hence, in the preferred embodiment it is concluded that the packet may not have been received error-free. Therefore, the method includes trying to recover the payload using forward error correction decoding. The skilled person is well aware of different methods of forward error correction decoding that may be implemented.

In a preferred embodiment, in case the integrity check is passed, the method further includes determining that the payload encoded in the plurality of packets has been received error free, discarding any other packets of the multiple packets already received at the receiver carrying the same payload, and discarding any other packets of the multiple packets subsequently received at the receiver carrying the same payload.

Hence, in the preferred embodiment the receiver stops any further action aiming to decode packets carrying the same payload in encoded form. To this end, any previously received packet carrying encoder output bits selected from the same set of encoder output bits that were not successfully decoded and therefore kept for combination with other packets is discarded and any future packet received from the same transmitter carrying encoder output bits from the same set of encoder output bits is also discarded. Packets received from the same transmitter may, for example, be identified using a transmitter identifier or a protocol identifier such as a syncword or a preamble included in a header of the packet. Alternatively or additionally, packets could also be identified based on the timing in which they are received. This includes considering the spacing in time between subsequent packages and/or the time window over which the packets are received.

In a further preferred embodiment, after obtaining a corresponding payload bit from a received encoder output bit with an inverse of the determined convolutional encoder, the method further includes encoding the corresponding payload bit with the remaining convolutional encoders of the plurality of different convolutional encoders to update a state of each of the remaining convolutional encoders.

Hence, in the preferred embodiment, the receiver moves to update the state of all other inverse convolutional encoders after a payload bit was recovered using one of the inverse convolutional receivers. This may be necessary if according to the selected puncturing pattern, encoder output bits from more than one convolutional encoder were included in the received packet since the state of a convolutional encoder depends on the bits previously encoded with said convolutional encoder.

To this end, a receiver comprising L convolutional encoders corresponding to the L convolutional encoders of the transmitter. In other words, the L convolutional encoders of the receiver have polynomials identical to those of the convolutional encoders of the transmitter. Thus, for each inverse convolutional encoder with the encoder transfer function *H*⁻¹(*z*) the receiver has a corresponding (non-inverse) convolutional encoder with the encoder transfer function H(z). The corresponding inverse and non-inverse convolutional encoders share their state. This may, for example, be achieved using a tapped delay line shared between a convolutional encoder with the encoder transfer function H(z) and an inverse convolutional encoder with the encoder transfer function *H*⁻¹(*z*). The shared state of a convolutional encoder and the corresponding inverse convolutional encoder will be the same regardless as to whether a payload bit is encoded with the convolutional encoder or the encoder output bit corresponding to that payload bit is decoded using the corresponding inverse convolutional decoder. Hence, after decoding one bit using one of the inverse convolutional encoders, the decoded bit is fed back into the other convolutional encoders at the receiver to update the combined state of the convolutional encoders and their inverses.

This advantageously allows keeping the state of all inverse convolutional decoders of the receiver up to date using the already decoded payload bits.

In a preferred embodiment, each packet of the multiple packets further comprises at least one redundant bit selected at the transmitter from the encoder output bits according to the packet-specific puncturing pattern, wherein the one or more redundant bits carry information redundant to at least one other encoder output bit included in the subset of encoder output bits selected for the respective packet. The received packet comprises at least one received redundant bit. After obtaining one or more payload bits from which the at least one received redundant bit was obtained at the transmitter as part of the encoder output bits, the one or more obtained payload bits are encoded with the respective convolutional encoders at the receiver to obtain the encoder output bits corresponding to the redundant bits. In case the at least one received redundant bit does not match the at least one redundant bit obtained at the receiver from the one or more obtained payload bits, it is determined that the packet was not received error free and/or the selected packet-specific puncturing pattern was not used at the transmitter to select the encoder output bits for the received packet.

Hence, in the preferred embodiment, the received packet comprises more received encoder output bits than necessary to convey the information included in the original payload. At least one of these additional bits carries redundant information which adds error correction information. Preferably, the received packet comprises multiple redundant bits forming a set of redundant bits. The redundant bits are also selected at the transmitter from the output of the convolutional encoders based on the puncturing pattern, i.e., from the encoder output bits. In other words, the subset *Sₙ* of bits selected for a packet n comprises a set of non-redundant encoder output bits *Dₙ* making the packet individually decodable and a set of redundant bits *Rₙ* carrying redundant information, i.e., *Sₙ* = *Dₙ* ∪ *Rₙ* and *Rₙ* ∩ *Dₙ* = ∅.

The redundant bits are obtained from the same payload bits as the non-redundant bits and selected for the received packet using the same packet-specific puncturing pattern. Therefore, at the receiver the redundant bits can advantageously be used to perform an early verification whether the correct puncturing pattern was selected and/or whether the packet was received error free.

To this end, the decoded payload bits obtained at the receiver are fed into convolutional encoders corresponding to the convolutional encoders that were to obtain the redundant bits at the transmitter. The redundant bits obtained at the receiver have to be identical to the redundant bits received from the transmitter if the packet was received without errors. Simultaneously, the states of the corresponding inverted convolutional encoders are kept up to date by feeding back the decoded payload bits.

The receiver thus essentially creates a receiver version of the redundant bits and can identify which convolutional encoder created the redundant bits from which payload bits from the selected packet-specific puncturing pattern. If the correct puncturing pattern was selected and if the packet was received error-free, the received redundant bits are identical to the redundant bits created by the receiver from the decoded payload bits. If there is a discrepancy, either the packet was not received error-free, or a different puncturing pattern was used at the transmitter for selecting the encoder output bits and the payload bits for the received packet. Hence, comparing the received redundant bits to the redundant bits created at the receiver from the decoded payload bits allows performing an integrity check.

The integrity check based on comparing the one or more received redundant bits to the one or more redundant bits created at the receiver from the decoded payload can be made while the decoding of the payload bits is ongoing, i.e., whenever a decoded payload bit has been obtained at the receiver, it is immediately encoded at the receiver using the convolutional encoders to obtain the corresponding encoder output bits. If among the newly created encoder output bits is one of the one or more redundant bits included in the received packet, the comparison of the received redundant bit and the redundant bit created from the decoded payload bits can be performed immediately. In case the two bits do not match, it can be concluded that either the wrong puncturing pattern was selected or that the packet was not received error-free. Processing of the received packet using the selected packet-specific puncturing pattern can be stopped in case the received redundant bit does not match the redundant bit obtained from the decoded payload bits. Since a redundant bit may have been generated from a few payload bits only, decoding of the received encoder output bits can be terminated after these few payload bits have been decoded.

Preferably, each packet comprises at least N redundant bits, wherein N is greater than or equal to 5 and preferably greater than or equal to 7. In case each of the N received redundant bits matches the corresponding redundant bit obtained at the receiver from the decoded payload bits, it is determined that the selected packet-specific puncturing pattern was used at the transmitter to select the encoder output bits for the received packet.

Hence, in the preferred embodiment at least five and preferably seven or more redundant bits are included in each packet. Thus, if five or more and preferably seven or more redundant bits can be correctly obtained from the decoded payload bits, it can be concluded that it is likely that the correct polynomial was chosen and that the encoder output bits from which the redundant bit was obtained at the transmitter were received error free. Since there is a 50% chance of a false positive for each redundant bit, the chance of obtaining five redundant bits correctly from a received packet using the wrong puncturing pattern is about 3%. Obtaining 7 or more received redundant bits from decoded payload bits is even less likely, i.e., the chance is less than 1%. In other words, after successfully obtaining seven redundant bits from the decoded payload bits the chance that the correct polynomial was chosen is greater than 99%. Thus, in case the decoding of the payload fails at later stage as indicated, for example, by a failed integrity check or by an incorrect redundant bit, the receiver can immediately begin forward error correction decoding on the packet. As it was determined that the correct puncturing pattern had been identified, there is no need to try further puncturing patterns. Furthermore, in case forward error correction on the current packet is not successful, the receiver can infer which puncturing pattern was used for the next packet that is received from the same transmitter.

In a further preferred embodiment, each packet of the multiple packets further comprises at least one of a plurality of header bits and a plurality of synchronization bits. The method further comprises the steps of determining a bit error rate of the at least one of a plurality of header bits and a plurality of synchronization bits of the received packet and stop processing the received packet if the determined bit error rate exceeds a threshold.

Hence, in the preferred embodiment the header and/or synchronization bits of a packet are decoded, and a bit error rate (BER) is determined for these bits. The BER of the header and/or synchronization bits is used as a measure for the overall BER of the received packet. In case the BER is so high that it is unlikely that decoding using the present method will be successful, processing of the current packet alone is stopped and the packet is saved for combination with other packets for forward error decoding.

In a preferred embodiment, all packet-specific puncturing patterns are configured so that all non-redundant encoder output bits received in a packet can be decoded using the inverse of the same convolutional encoder to obtain the corresponding payload bits. The bit error rate can be defined in different ways but essentially puts the number of faulty bits received from a transmitter in relation to the overall number of bits received from the transmitter. Since it can be determined beforehand at which bit error rate the error correction decoding of a single packet will fail without combining the packet with other packets, the bit error rate of the preamble and/or the header of packet can be compared to a threshold. If the bit error rate exceeds the threshold, it is unlikely that error correction decoding of the packet alone will be successful. In this case processing of the single packet is stopped and the packet is stored for combining with other packets as part of the incremental redundancy.

In a second aspect, the invention is directed to a receiver for wirelessly receiving a wireless transmission comprising multiple packets. The receiver is configured to perform the method according to any of the preceding embodiments. Since the receiver implements one or more embodiments of the previously described method, it is not described in more detail to avoid repetitions. Instead, reference is made to the above detailed description of the different embodiment of a method for fast decoding of a wireless transmission.

In a third aspect, the invention is directed to a system comprising a receiver according to the preceding embodiment and a transmitter. The transmitter is configured to transmit a payload comprising a plurality of payload bits in multiple packets, each packet of the multiple packets comprising a subset of a plurality of encoder output bits. To this end, the transmitter is configured to encode the payload bits with a plurality of different convolutional encoders for forward error correction to obtain the plurality of encoder output bits, select the subset for each packet according to a packet-specific puncturing pattern from the plurality of encoder output bits, and transmit the packet. The packet-specific puncturing pattern is selected at the transmitter from a set of predetermined packet-specific puncturing patterns. The packet-specific puncturing patterns are configured so that each packet of the multiple packets is individually decodable.

Preferably, the packet-specific puncturing patterns are configured so that each packet comprises only encoder output bits obtained using one convolutional encoder of the plurality of different convolutional encoders.

The system thus includes at least one transmitter and a receiver as previously described. Different ways of implementing the at least one transmitter and the functioning thereof have already been described as part of the above preferred embodiments of a method for fast decoding of a wireless transmission. The receiver corresponds to the previously described receiver. Therefore, to avoid unnecessary repetitions, reference is made to the preceding description of the preferred embodiments of the method for details, exemplary embodiments and advantages of the system.

In the following, an example embodiment of system for fast decoding of multi-packet transmissions comprising an exemplary embodiment of a receiver and implementing an exemplary embodiment of a method for fast decoding of multi-packet transmissions will be described with reference to the drawings, wherein
- Figure 1: shows an exemplary embodiment of a system comprising a receiver and a plurality of transmitters,
- Figure 2: shows an exemplary embodiment of a structure of a packet,
- Figure 3: shows an exemplary embodiment of a wireless multi-packet transmission,
- Figure 4: shows a functional sketch of an exemplary embodiment of a method for encoding a payload,
- Figure 5: shows a functional sketch of an exemplary embodiment of a method for fast decoding of a wireless transmission,
- Figure 6: shows a schematic drawing of an exemplary embodiment of a convolutional encoder and an inverse convolutional encoder with a shared state, and
- Figure 7: shows a flow chart of an exemplary embodiment of a method for fast decoding of a wireless transmission comprising multiple packets.

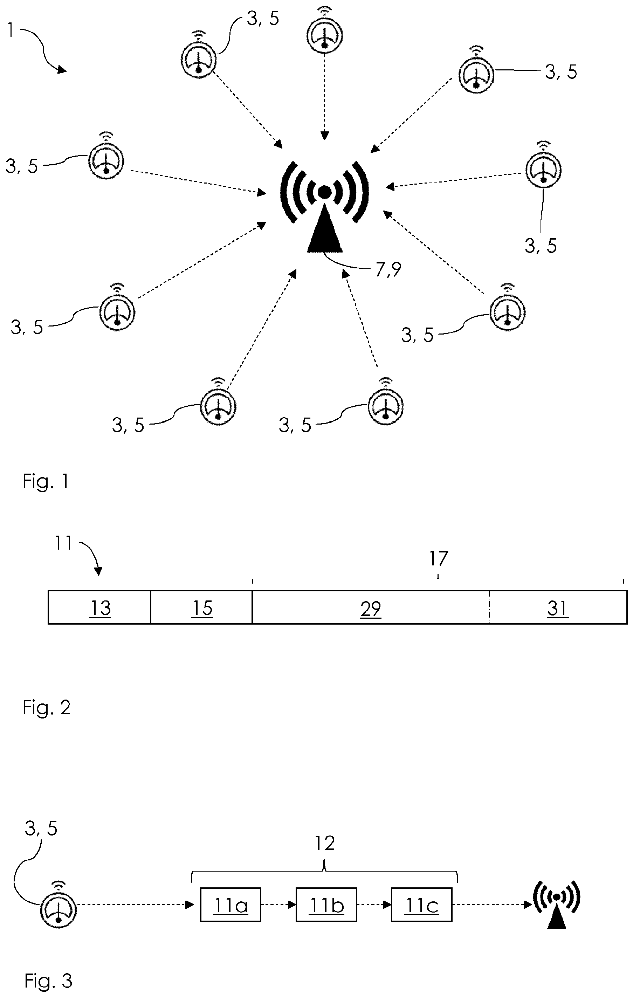

Figure 1 shows an exemplary embodiment of a wireless data transmission system 1 operating on an LPWAN protocol. The system 1 comprises a plurality of smart meters 3 each comprising a transmitter 5 and a single base station 7 comprising a receiver 9. The transmitters 5 and the receiver 9 are not shown as individual components in the figures. However, it is understood that each transmitter and each receiver comprise at least one antenna, receive and/or transmit circuitry and at least one processor for encoding or decoding data. The LPWAN protocol as shown in Figure 1 only uses unidirectional communication from the transmitters 5 to the receiver 9 but not in the opposite direction. However, all devices 3, 7 may also include transceivers and the system 1 may allow bidirectional communication between the smart meters 3 and the base station 7.

The smart meters 3 transmit measurement results to the base station 7 at regular or irregular intervals. Since the smart meters 3 in the exemplary embodiment are battery powered, the power available for wireless data transmission is limited. Note that the batteries are not shown in the figures. The limitation is not only caused by the fact that the battery needs to keep the device operation for timespans ranging between 10 years and 20 years and conserving power is critical for such batteries, but also by the fact that only a very limited current can be drained from these batteries. Due to limited current directly available from the battery, the smart meters 3 comprise additional capacitors which provide the power required for data transmission to the base station 7. High-quality capacitors are expensive. Therefore, keeping the power required for data transmissions low also benefits the production costs of the smart meters 3.

One straightforward way of limiting the power required for sending a transmission is the reduction of the on-air time, i.e., the time it takes to send out a message. Reducing the on-air time can, in particular, be achieved by reducing the number of bits that are transmitted with every packet.

An exemplary structure of a packet 11 is shown in Figure 2. The packet 11 comprises a synchronization section 13, a header 15 and a payload section 17. The bits of the synchronization section 13 allow the transmitter to detect that a packet is being received and enable the receiving of the subsequent information. The header section 15 includes information that is deemed essential for processing the packet 11, but none of that information is related to the measurement results that shall be transmitted from the smart meter 3 to the base station 7. This information is entirely included in the payload section 17 which additional carries error correction information. One straightforward way of reducing the length of a packet 11 and thereby the on-air time is to remove information from the packet's header or header section 15 that is not essential for successfully decoding the packet 11.

Another way of reducing the on-air time is the implementation of incremental redundancy, where a payload encoded for forward error correction at the transmitter 5 is split into multiple packets 11a, 11b, 11c, i.e., the packets 11a, 11b, 11c form a multi-burst or multi-packet transmission 12 as shown schematically in Figure 3. The bits for each of the packets 11a, 11b, 11c are selected from the payload bits encoded at the transmitter 5 so that the payload can be obtained at the receiver9 using forward error correction decoding from each of the packets 11a, 11b, 11c independently. In case it should not be possible to decode the packets 11a, 11b, 11c individually, one or more received packets 11a, 11b, 11c can be combined to increase the amount of redundant information available for forward error correction. Using incremental redundancy reduces the on-air time required for each individual packet 11a, 11b, 11c as compared to a single packet including all payload and error correction bits. Therefore, smaller capacitors at the transmitter 5 in the smart meter 3 can be used as less energy is required per transmission.

It should be noted that in prior art implementations of LPWAN protocols using incremental redundancy, the header of each packet 11a, 11b, 11c of a multi-packet transmission comprises an identifier allowing a receiver 9 of a packet of the multi-packet transmission to identify which packet 11a, 11b, 11c in the sequence of packets 11a, 11b, 11c has been received. This identifier is not included in the header 15 of the packets 11 in the exemplary embodiments. The fast-decoding method implemented by the receiver 9 does not require a packet identifier in the header. By shortening the header, the overall length of the packet 11 and thus the on-air time can be reduced, thereby reducing the power consumption at the transmitter 5 in the battery-powered smart meter 3. However, it is noted that the method could also be implemented if the header would include a packet identifier.

Another benefit of reducing the on-air time is achieved at the receiver 9. In the example shown in Figure 1, nine smart meters 3 are transmitting packets 11 with measurements results to the base station 7. In a real-life implementation of a smart meter network, several hundred or several thousand smart meters 3 will be associated with a single base station 7. Since none of the smart meters 3 is aware of any of the other smart meters 3, the transmissions of the smart meters 3 are not coordinated, the transmission medium at the receiver9 may be congested and transmissions from different transmitters 5 can collide. Reducing the transmission time of each packet 11, i.e., the time each packet 11 occupies the transmission medium reduces the risk of collisions and increases the chances that the payload of a packet can be decoded successfully.

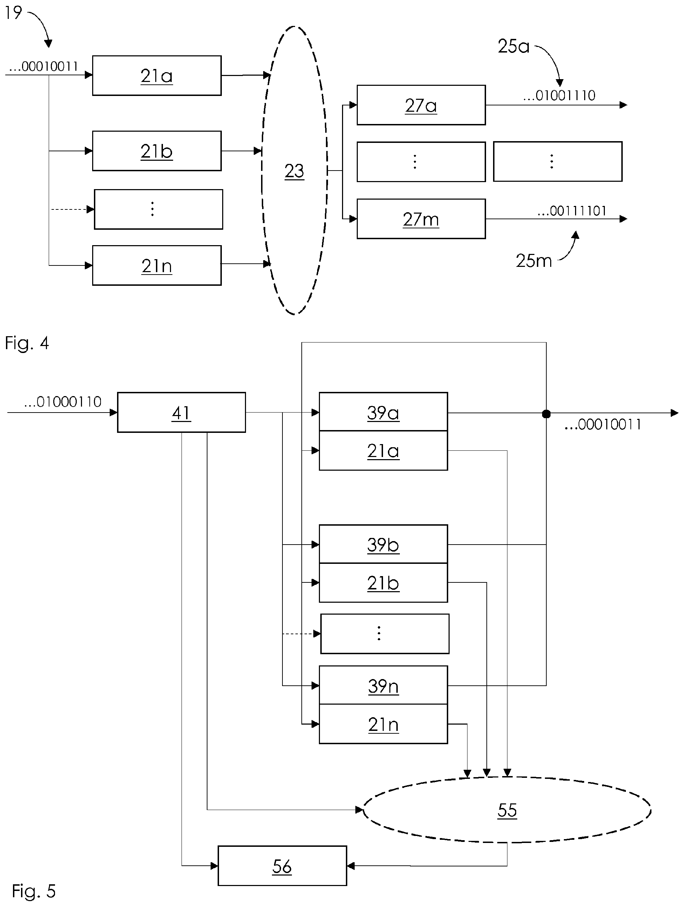

Subsequently, an exemplary embodiment of a method for encoding a payload 19 for a multi-packet or multi-burst transmission will be described with reference to Figure 4. The exemplary method will be described largely in generic terms as it can be applied for many different packets. In addition, it will be shown how the method is applied to a first and a second exemplary embodiment with a given payload that is encoded using concrete polynomials and specific puncturing patterns for three packets.

In the exemplary embodiment, the payload 19 comprises in total M bits made up from data bits and integrity check bits. The data bits carry information such as measurement data that shall be sent from the transmitter 5 to the receiver 9, whereas the integrity check bits are included in the payload to verify whether the payload 19 has been correctly decoded at the receiver 9. In the first exemplary embodiment, the payload 19 has 14 bits: 10111100010011. In the second exemplary embodiment, the payload 19 comprises 14 bytes: BC4D789AF135E26BC4D789AF135E.

At the transmitter 9, the payload 19 of M bits is encoded using L convolutional encoders 21a, 21b, ..., 21n. Each of the L convolutional encoders employs a different polynomial or encoder transfer function *H*(*z*)*.* The encoder transfer function can be represented as *H*(*z*) = *g*₀(*z*)/*g*₁(*z*). In both the first exemplary embodiment and the second exemplary embodiment, four convolutional encoders are used for encoding the payload 19. The following encoder transfer functions are employed in the first and second exemplary embodiment: ${H}_{1} \left(z\right) = \frac{0115}{0115} ,$ ${H}_{2} \left(z\right) = \frac{0163}{0115} ,$ ${H}_{3} \left(z\right) = \frac{0147}{0115}$ and ${H}_{4} \left(z\right) = \frac{0135}{0115} .$ Note that he first encoder transfer function is the unity function, i.e., the encoded bits are identical to the unencoded bits.

Propagating the above payloads according to the first and second exemplary embodiment through the four convolutional encoders with the encoder transfer functions *H*₁(*z*), *H*₂(*z*), *H*₃(*z*), *H*₄(*z*) yields for the first exemplary embodiment the following four encoded payloads EP: ${EP}_{1} = 10 1111 0001 0011 ,$ ${EP}_{2} = 11 0111 1100 0001 ,$ ${EP}_{3} = 11 1111 0100 1111$ and ${EP}_{4} = 10 0101 0001 1110 .$ Encoding the payload 19 of the second exemplary embodiment yields the following four encoded payloads EP: ${EP}_{1} = BC 4 D 789 AF 135 E 26 BC 4 D 789 AF 135 E ,$ ${EP}_{2} = DF 074536 E 0283620 B 8 CA 9 D 7493 FE ,$ ${EP}_{3} = FD 3 CEDA 018121 F 97 B 98 B 2 C 7155 AA and$ ${EP}_{4} = 947 B 58223 BA 896 F 83 A 29 B 70141 B 1 .$

The combined output of all L convolutional encoders 21a, 21b, ..., 21n is subsequently referred to as the set *S* of encoder output bits 23. The set of encoder output bits comprises L· M bits. From the set of encoders bits, subsets *S*₁, *S*₂, ..., *Sₙ* of encoder output bits 25a, ..., 25m are selected for the N packets 11 to be transmitted according to packet-specific puncturing patterns 27a, ..., 27m.

In the first and second exemplary embodiment, three packets 11a, 11b, 11c shall be transmitted from the transmitter 5 to the receiver 9. Each of the packets 11a, 11b, 11c of the first exemplary embodiment comprises 16 bits: 14 bits are selected to represent the information contained in the payload 19, whereas the remaining two bits are redundant bits carrying redundant information that is intended to be used for forward error correction at the receiver 9. Likewise, each of the packets 11a, 11b, 11c of the second exemplary embodiment comprises 16 bytes. 14 bytes carry the information of the payload 19 and two bytes carry redundant information intended for forward error correction. In Figure 2 this is shown by the dashed line separating the payload section 17 of the packet 11 into a non-redundant section 29 carrying the non-redundant bits and a redundant section 31 carrying the additional redundant bits for forward error correction.

The packet-specific puncturing patterns 27a, ..., 27m of the first and second exemplary embodiment are configured in a similar way for selecting encoder output bits from different convolutional encoders 21a, 21b, ..., 21n. For example, the first puncturing pattern 21a is configured for selecting all encoder output bits obtained using the first convolutional encoder 21a as the bits representing the payload 19. Further, the 7^{th} and 14^{th} bit are selected from the output of the fourth convolutional encoder. For the second subset 25b, all encoder output bits from the second convolutional encoder 21b and the 6^{th} and 13^{th} bit are selected from the fourth convolutional encode. For the third subset 25c, all encoder output bits from the third convolutional encoder 21b and the 5^{th} and 12^{th} bit are selected from the fourth convolutional encoder. Similarly, for the second exemplary embodiment, the corresponding puncturing patterns are implemented by selecting entire bytes of encoder output bits instead of individual bits. Applying the above puncturing patterns yields the following subsets for the first exemplary embodiment: ${S}_{1} = 1011 1100 0100 1110 ,$ ${S}_{2} = 1101 1111 0000 0100 ,$ and ${S}_{3} = 1111 1101 0011 1101 .$ For the second exemplary embodiment, the following subsets are obtained: ${S}_{1} = BC 4 D 789 AF 135 E 26 BC 4 D 789 AF 135 EA 6 A 0 ,$ ${S}_{2} = DF 074536 E 0283620 B 8 CA 9 D 7493 FE 2489 ,$ and ${S}_{3} = FD 3 CEDA 018121 F 97 B 98 B 2 C 7155 AA 4 B 99 .$

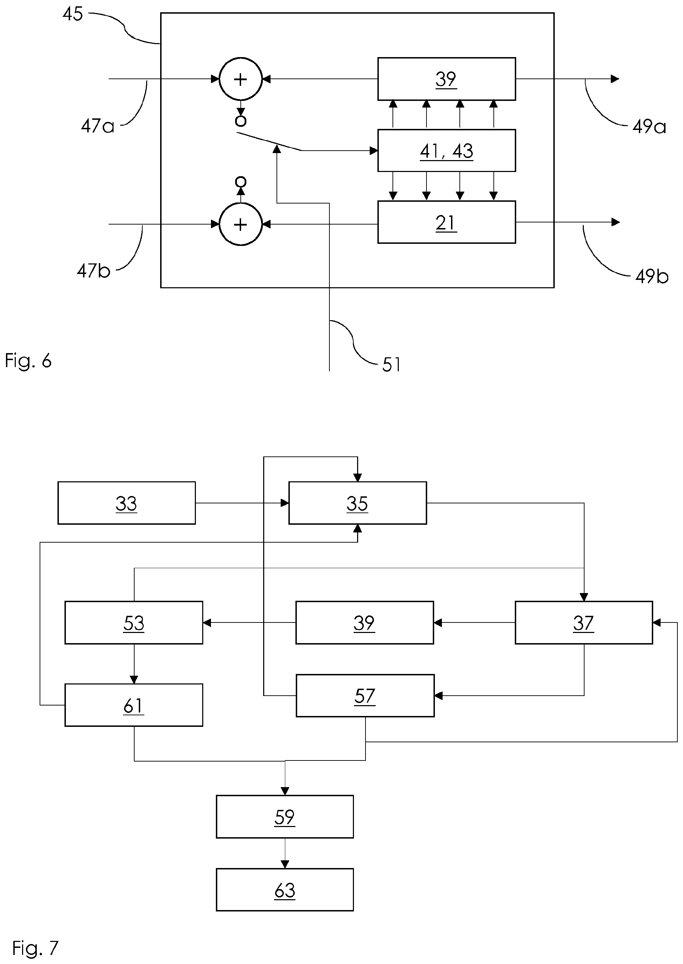

The subsets selected according to the puncturing patterns are transmitted using packets 11 from the transmitter 5 to the receiver 9. Subsequently, an exemplary embodiment of a method for fast decoding of a received packet 11 will be described in more detail with reference to Figure 5 and 6. Figure 5 is a flow chart schematically depicting how the received bits of a packet are decoded, whereas Figure 7 outlines the steps performed according to the exemplary embodiment of the method.

After receiving a packet 11 of the multi-packet transmission at a receiver 9, the receiver 9 first processes the synchronization section 13 and the header 15 in a well-known manner which is not described in any more detail here. However, it is noted that the receiver 9 does not obtain any indication from the header 15 of the packet 11 as which packet 11 in the multi-packet transmission 12 has been received, i.e., the receiver 9 does not positively know which packet 11 of the sequence of packets 11 has been received.

Before commencing the actual decoding of the payload section 17 of the received packet 11, in a first step 33 the receiver 9 determines the bit error rate (BER) of the header 15 and the synchronization section 13 of the received packet. If the BER exceeds a predetermined threshold, the receiver 9 determines that it is unlikely that forward error decoding the packet 11 alone without the additional redundant information from the other packets 11 of the multi-burst transmission 12 will be successful. In this case, the processing of the packet 11 alone is terminated and it is stored for further combined forward error decoding with other packets of the multi-packet transmission 12. In case the BER is below the threshold, the method moved to the second step 35.

In the second step 35, a packet-specific puncturing pattern is selected at the receiver 9 which could have been used to select the received encoder output bits at the transmitter 5. In the present embodiment, unless the receiver 9 is aware that other packets from the same multi-burst transmission have already been received and decoded unsuccessfully, the receiver 9 commences with the puncturing pattern applied for the first packet 11a in the multi-burst transmission 12. If the receiver 9 is aware of other packets 11 from the same multi-burst transmission, the receiver 9 aims to infer from the previously received packets 11 which puncturing pattern may have been used for the current packet 11. For example, the receiver 9 may have been able to establish for a previously received packet the correct puncturing pattern but failed to decode the packet 11 due to transmission errors. In that case, the receiver 9 can conclude which puncturing pattern must have been used for the current packet 11.

The receiver 9 next tries decoding the received encoder output bits using convolutional encoders 39a, 39b, ..., 39n with inverse polynomials compared to the convolutional encoders 21a, 21b, ..., 21n used at the transmitter 5 for encoding the payload 19. Hence, for every encoder 21a, 21b, ..., 21n at the transmitter 5, there is a corresponding inverse convolutional encoder 39a, 39b, ..., 39n at the receiver 9. For a convolutional encoder21a, 21b, ..., 21n with the encoder transfer function $H \left(z\right) = \frac{{g}_{0} \left(z\right)}{{g}_{1} \left(z\right)}$ , the corresponding inverse convolutional encoder 39a, 39b, ..., 39n has the encoder transfer function ${H}^{- 1} \left(z\right) = \frac{{g}_{1} \left(z\right)}{{g}_{0} \left(z\right)}$. Assuming that the packet 11 was received error-free, the inverse convolutional encoders 39a, 39b, ..., 39n can be used to retrieve the original payload with a minimum of computational effort.

For decoding the received encoder output bits, each received bit is processed individually. In the third step 37, a puncturing unit 41 at the receiver establishes for each bit from which of the L convolutional encoders 21a, 21b, ..., 21n had been used to obtain the respective bit (provided that the correct packet-specific puncturing pattern has been selected) and whether the respective bit is a non-redundant bit or a redundant bit.

Assuming that a bit carries non-redundant information, it is propagated in the fourth step 39 through the inverse convolutional encoder 39a, 39b, ..., 39n of the convolutional encoder 21a, 21b, ..., 21n which produced the respective bit at the transmitter 5 according to the puncturing pattern. Provided that the correct puncturing pattern has been used and that the payload section 17 of the packet 11 was received error free, in this way the payload bit can be obtained without having to perform forward error decoding. This greatly reduces the computational resources required for decoding the payload.

To be able to decode further received bits that were obtained at the transmitter 5 using a different convolutional encoder 21a, 21b, ..., 21n than the convolutional encoder 21a, 21b, ..., 21n that was used to obtain the last received bit, the state of the other inverse convolutional encoders 39a, 39b, ..., 39n needs to be updated. To this end, the receiver 9 comprises for every inverse convolutional encoder 39a, 39b, ..., 39n with the encoder transfer function *H*⁻¹(*z*) the corresponding non-inverted convolutional encoder 21a, 21b, ..., 21n with the encoder transfer function H(z). As shown schematically in Figure 6, every inverse convolutional encoder 39 at the receiver 9 shares it state 41 with a corresponding non-inverted convolutional encoder 21. The state 41 is in the exemplary embodiment formed by a tapped delay line 43. The conceptual combination of the convolutional encoder 21 and the inverse convolutional encoder 39 with the shared state 41 is subsequently referred to as a bidirectional encoder 45.

The bidirectional encoder 45 has two inputs and two outputs: a first input 47a for encoded bits, a second input 47b for decoded bits, a first output 49a for decoded bits, and a second output 49b for encoded bits. At the input, a control line 51 is provided for switching between the first input 47a and the second input 47b. For decoding a received bit, the control line 51 activates the first input 47a. The received bit is propagated through the inverse convolution encoder 39 and the state 41 of the both the inverse convolutional encoder 39 and non-inverted convolutional encoder 21 are updated. The decoded bit is obtained at the corresponding first output 49a.

After a received bit has been decoded with one of the inverse convolutional decoders 39a, 39b, ..., 39n, for example, with the inverse convolutional decoder 39a, the status of all other convolutional decoders 39b, ..., 39n is updated in the fifth step 53 by propagating the decoded bit through the non-inverted convolutional decoders 21b, ..., 21n. To this end, the just decoded bit is sent to the respective inputs 47b for decoded bits and the control line 51 is set so that the bidirectional encoder 45 processes decoded bits. At the output 49b of the bidirectional encoder 45, the respective encoded bits are obtained and stored collectively as encoder output bits 55.

Once a received bit has been decoded and the states of all other inverse convolutional encoders 39a, 39b, ..., 39n have been updated, the receiver 39 returns to the third step 37 for processing the next received bit by determining based on the selected puncturing pattern whether the next bit is redundant and which encoder 21a, 21b, ..., 21n supposedly produced the respective bit at the transmitter 5. If the subsequent bit carries non-redundant information, the previous processing steps are repeated. However, if the next received bit is a redundant bit, processing proceeds to the sixth step 57.

According to the sixth step 57, it is determined whether the received redundant bit can be obtained from the decoded bits at the receiver 9. For example, if the received redundant bit was according to the selected puncturing pattern obtained by encoding the first seven payload bits at the fourth convolutional encoder, the same redundant bit should be obtained from the fourth non-inverted convolutional encoder 21 when encoding the seventh decoded bit. The comparison is performed in Figure 5 using a compare unit 56.

If the two bits are identical, it can be concluded that it is likely that the packet 11 was received until this bit error-free. Further, in case seven or more redundant bits have been successfully obtained from decoded payload bits, the likelihood of having selected the correct puncturing pattern is > 99%. However, if a received redundant bit does not match the redundant bit obtained from the decoded payload bits, a new puncturing pattern can be selected, i.e., the method moves to the second step 35. If all puncturing patterns have been tried or if it has been determined at an earlier stage that the correct puncturing pattern was used, the receiver9 tries decoding the packet 11 using forward error correction decoding in a seventh step 59.

Note that if the redundant bit is, for example, transmitted as one of the last bits in a packet 11 but from the puncturing pattern is known that the redundant bit was obtained by encoding only a few of the payload bits, the redundant bit can and should be processed as soon as all bits have been decoded that are required for establishing whether the redundant bit can be obtained from the decoded bits. In case a redundant bit cannot be successfully obtained from the decoded bits, fast decoding of the packet 11 without forward error decoding can be terminated early to preserve processing resources.

Finally, after all received encoder output bits have been decoded at the receiver, in an eight step 61 an integrity check is performed using CRC bits that are included in the payload 19. If the integrity check is successful, it is concluded that the payload has been successfully decoded, processing of all other packets 11 of the same multi-packet transmission 12 is halted, and the remaining packets 11 are discarded.

In case the integrity check shows that decoding was not successful, forward error correction decoding is performed according to the seventh step 59. If forward error correction decoding also fails, the packet is stored in a nineth step 63 for further combination with other packets 11 to implement the established concept of incremental redundancy.

### List of reference numerals

- 1: system
- 3: smart meter
- 5: transmitter
- 7: base station
- 9: receiver
- 11, 11a, 11b, 11c: packet
- 12: multi-packet transmission
- 13: synchronization section
- 15: header
- 17: payload section
- 19: payload
- 21a, 21b, ..., 21n: convolutional encoder
- 23: set of encoder output bits
- 25a, ...,: 25m subsets of encoder output bits
- 27a, ...,: 27m packet-specific puncturing patterns
- 29: non-redundant section
- 31: redundant section
- 33: first step
- 35: second step
- 37: third step
- 39a, 39b, ..., 39n: inverse convolutional encoder
- 41: state of inverse convolutional encoder
- 43: tapped delay line
- 45: bi-directional convolutional encoder
- 47a, 47b: input
- 49a, 49b: output
- 51: control line
- 53: fifth step
- 55: encoder output bits
- 56: compare unit
- 57: sixth step
- 59: seventh step
- 61: eight step
- 63: nineth step

## Claims

1. A method for fast decoding of a wireless transmission comprising multiple packets (11, 11a, 11b, 11c) to obtain a payload comprising a plurality of payload bits at a receiver (9), wherein each packet (11, 11a, 11b, 11c) of the multiple packets (11, 11a, 11b, 11c) comprises a subset (25a, ..., 25m) of a plurality of encoder output bits, wherein the plurality of encoder output bits was obtained at a transmitter (5) by encoding the payload bits with a plurality of convolutional encoders (21a, 21b, ..., 21n) with different polynomials and wherein the subset (25a, ..., 25m) for each packet (11, 11a, 11b, 11c) was selected according to a packet-specific puncturing pattern (27a, ..., 27m) from the plurality of encoder output bits, wherein the packet-specific puncturing pattern (27a, ..., 27m) is selected at the transmitter (5) from a set of predetermined packet-specific puncturing patterns (27a, ..., 27m) and wherein each subset (25a, ..., 25m) of the plurality of encoder output bits selected for a packet (11, 11a, 11b, 11c) of the multiple packets (11, 11a, 11b, 11c) allows decoding the entire payload, the method comprising the following steps:
receiving a packet (11, 11a, 11b, 11c) of the multiple packets (11, 11a, 11b, 11c) at the receiver (9), the packet (11, 11a, 11b, 11c) comprising a plurality of received encoder output bits,
selecting a packet-specific puncturing pattern (27a, ..., 27m) from the set of predetermined packet-specific puncturing patterns (27a, ..., 27m), **characterised in that**:
based on the selected packet-specific puncturing pattern (27a, ..., 27m), for each received encoder output bit in the received packet (11, 11a, 11b, 11c) determining the convolutional encoder (21a, 21b, ..., 21n) that would have been used to obtain the respective encoder output bit according to the selected packet-specific puncturing pattern (27a, ..., 27m) and using an inverse of the determined convolutional encoder (21a, 21b, ..., 21n) to decode the respective encoder output bit to obtain the corresponding payload bit, and
after decoding all received encoder output bits of the received packet, perform an integrity check of the obtained payload bits to determine whether the packet (11, 11a, 11b, 11c) was received error free and whether the selected packet-specific puncturing pattern (27a, ..., 27m) was used at the transmitter (5) to select the encoder output bits for the received packet (11, 11a, 11b, 11c).

2. Method according to claim 1, wherein in case the integrity check failed, the method further comprises the following steps:
select an other packet-specific puncturing pattern (27a, ..., 27m) from the set of predetermined packet-specific puncturing patterns (27a, ..., 27m),
based on the other packet-specific puncturing pattern (27a, ..., 27m), for each received encoder output bit in the received packet (11, 11a, 11b, 11c) determine the convolutional encoder (21a, 21b, ..., 21n) used to obtain the respective encoder output bit and use an inverse of the determined convolutional encoder (21a, 21b, ..., 21n) to decode the respective encoder output bit to obtain the corresponding payload bit, and
after decoding all received encoder output bits of the received packet (11, 11a, 11b, 11c) using the other packet-specific puncturing pattern (27a, ..., 27m), perform an integrity check of the obtained payload bits to determine whether the packet (11, 11a, 11b, 11c) was received error free and whether the other packet-specific puncturing pattern (27a, ..., 27m) was used at the transmitter (5) to select the encoder output bits for the received packet (11, 11a, 11b, 11c).

3. Method according to claim 1 or 2, wherein in case the integrity check fails for at least one packet-specific puncturing pattern (27a, ..., 27m) and preferably all packet-specific puncturing patterns (27a, ..., 27m) in the set of predetermined packet-specific patterns for the received packet (11, 11a, 11b, 11c), the method includes trying to decode the received packet (11, 11a, 11b, 11c) using forward error correction.

4. Method according to any of the preceding claims, wherein in case the integrity check fails for all packet-specific puncturing patterns (27a, ..., 27m) in the set of predetermined packet-specific patterns for two or more received packets (11, 11a, 11b, 11c), the method includes combining at least two of the received packets (11, 11a, 11b, 11c) for forward error correction.

5. Method according to any of the preceding claims, wherein in case the integrity check is passed, the method includes determining that the payload encoded in the plurality of packets (11, 11a, 11b, 11c) has been received error free, discarding any other packets (11, 11a, 11b, 11c) of the multiple packets (11, 11a, 11b, 11c) already received at the receiver (9) carrying the same payload, and discarding any other packets (11, 11a, 11b, 11c) of the multiple packets (11, 11a, 11b, 11c) subsequently received at the receiver (9) carrying the same payload.

6. Method according to any of the preceding claims, wherein after obtaining a corresponding payload bit from a received encoder output bit with an inverse of the determined convolutional encoder (21a, 21b, ..., 21n), encode the corresponding payload bit with the remaining convolutional encoders (21a, 21b, ..., 21n) of the plurality of different convolutional encoders (21a, 21b, ..., 21n) to update a state (41) of each of the remaining convolutional encoders (21a, 21b, ..., 21n).

7. Method according to any of the preceding claims, wherein each packet (11, 11a, 11b, 11c) of the multiple packets (11, 11a, 11b, 11c) further comprises at least one redundant bit selected at the transmitter (5) from the encoder output bits according to the packet-specific puncturing pattern (27a, ..., 27m), wherein the one or more redundant bits carry information redundant to at least one other encoder output bit included in the subset (25a, ..., 25m) of encoder output bits selected for the respective packet,
wherein the received packet (11, 11a, 11b, 11c) comprises at least one received redundant bit,
wherein after obtaining one or more payload bits from which the at least one received redundant bit was obtained at the transmitter (5) as part of the encoder output bits, the one or more obtained payload bits are encoded with the respective convolutional encoders (21a, 21b, ..., 21n) at the receiver (9) to obtain the encoder output bits corresponding to the redundant bits,
wherein in case the at least one received redundant bit does not match the at least one redundant bit obtained at the receiver (9) from the one or more obtained payload bits, it is determined that the packet (11, 11a, 11b, 11c) was not received error free and/or the selected packet-specific puncturing pattern (27a, ..., 27m) was not used at the transmitter (5) to select the encoder output bits for the received packet.

8. Method according to claim 7, wherein each packet (11, 11a, 11b, 11c) comprises at least N redundant bits, wherein N is greater than or equal to 5 and preferably greater than or equal to 7,
wherein in case each of the N received redundant bits matches the respective redundant bit obtained at the receiver (9) from the decoded payload bits, it is determined that the selected packet-specific puncturing pattern (27a, ..., 27m) was used at the transmitter (5) to select the encoder output bits for the received packet (11, 11a, 11b, 11c).

9. Method according to any of the preceding claims, wherein each packet (11, 11a, 11b, 11c) of the multiple packets (11, 11a, 11b, 11c) further comprises at least one of a plurality of header bits and a plurality of synchronization bits, the method further comprising the steps of
determine a bit error rate of the at least one of a plurality of header bits and a plurality of synchronization bits of the received packet, and
stop processing the received packet (11, 11a, 11b, 11c) if the determined bit error rate exceeds a threshold.

10. Method according to any of the preceding claims, wherein all packet-specific puncturing patterns (27a, ..., 27m) are configured so that all non-redundant encoder output bits received in a packet (11, 11a, 11b, 11c) can be decoded using the inverse of the same convolutional encoder (21a, 21b, ..., 21n) to obtain the corresponding payload bits.

11. A receiver (9) for wirelessly receiving a wireless transmission comprising multiple packets (11, 11a, 11b, 11c), wherein the receiver (9) is configured to perform the method according to any of the preceding claims.

12. A system comprising a receiver (9) according to claim 11 and a transmitter (5),
wherein the transmitter (5) is configured to transmit a payload comprising a plurality of payload bits in multiple packets (11, 11a, 11b, 11c), each packet (11, 11a, 11b, 11c) of the multiple packets (11, 11a, 11b, 11c) comprising a subset of a plurality of encoder output bits,
wherein the transmitter (5) is configured to encode the payload bits with a plurality of different convolutional encoders (21a, 21b, ..., 21n) to obtain the plurality of encoder output bits, select the subset for each packet (11, 11a, 11b, 11c) according to a packet-specific puncturing pattern (27a, ..., 27m) from the plurality of encoder output bits, wherein the packet-specific puncturing pattern (27a, ..., 27m) is selected at the transmitter (5) from a set of predetermined packet-specific puncturing patterns (27a, ..., 27m) and wherein the packet-specific puncturing patterns (27a, ..., 27m) are configured so that each packet (11, 11a, 11b, 11c) of the multiple packets (11, 11a, 11b, 11c) is individually decodable, and transmit the packets (11, 11a, 11b, 11c).

13. A system according to claim 12,
wherein the packet-specific puncturing patterns (27a, ..., 27m) are configured so that each packet (11, 11a, 11b, 11c) comprises only encoder output bits obtained using one convolutional encoder (21a, 21b, ..., 21n) of the plurality of different convolutional encoders (21a, 21b, ..., 21n).

## Patentansprüche

1. Verfahren zum raschen Decodieren einer drahtlosen Übertragung, die mehrere Pakete (11, 11a, 11b, 11c) aufweist, um eine Nutzlast, die mehrere Nutzlastbits aufweist, zu erhalten, an einem Empfänger (9), wobei jedes Paket (11, 11a, 11b, 11c) der mehreren Pakete (11, 11a, 11b, 11c) einen Untersatz (25a, ..., 25m) von mehreren Codierer-Ausgangsbits aufweist, wobei die mehreren Codierer-Ausgangsbits an einem Sender (5) durch Codieren der Nutzlastbits mit mehreren Faltungscodierern (21a, 21b, ..., 21 n) mit unterschiedlichen Polynomen erhalten wurden, und wobei der Untersatz (25a, ..., 25m) für jedes Paket (11, 11a, 11b, 11c) gemäß einem paketspezifischen Punktierungsmuster (27a, ..., 27m) aus den mehreren Codierer-Ausgangsbits gewählt wurde, wobei das paketspezifische Punktierungsmuster (27a, ..., 27m) an dem Sender (5) aus einem Satz von vorherbestimmten paketspezifischen Punktierungsmustern (27a, ..., 27m) gewählt wird, und wobei jeder Untersatz (25a, ..., 25m) der mehreren Codierer-Ausgangsbits, der für ein Paket (11, 11a, 11b, 11c) der mehreren Pakete (11, 11a, 11b, 11c) gewählt wurde, ein Decodieren der gesamten Nutzlast gestattet, wobei das Verfahren die folgenden Schritte umfasst:
Empfangen eines Pakets (11, 11a, 11b, 11c) der mehreren Pakete (11, 11a, 11b, 11c) an dem Empfänger (9), wobei das Paket (11, 11a, 11b, 11c) mehrere empfangene Codierer-Ausgangsbits aufweist,
wählen eines paketspezifischen Punktierungsmusters (27a, ..., 27m) aus dem Satz von vorherbestimmten paketspezifischen Punktierungsmustern (27a, ..., 27m), **gekennzeichnet durch**:
Bestimmen, auf der Basis des gewählten paketspezifischen Punktierungsmusters (27a, ..., 27m), für jedes empfangene Codierer-Ausgangsbit in dem empfangenen Paket (11, 11a, 11b, 11c), des Faltungscodierers (21a, 21b, ..., 21n), der gemäß dem gewählten paketspezifischen Punktierungsmuster (27a, ..., 27m) verwendet worden wäre, um das jeweilige Codierer-Ausgangsbit zu erhalten, und Verwenden einer Umkehrung des bestimmten Faltungscodierers (21a, 21b, ..., 21 n) zum Decodieren des jeweiligen Codierer-Ausgangsbits, um das entsprechende Nutzlastbit zu erhalten, und
nach dem Decodieren aller empfangenen Codierer-Ausgangsbits des empfangenen Pakets, Durchführen einer Integritätsprüfung der erhaltenen Nutzlastbits, um zu bestimmen, ob das Paket (11, 11a, 11b, 11c) fehlerfrei empfangen wurde, und ob das gewählte paketspezifische Punktierungsmuster (27a, ..., 27m) an dem Sender (5) verwendet wurde, um die Codierer-Ausgangsbits für das empfangene Paket (11, 11a, 11b, 11c) zu wählen.

2. Verfahren nach Anspruch 1, wobei das Verfahren im Fall eines Fehlschlags der Integritätsprüfung ferner die folgenden Schritte umfasst:
Wählen eines anderen paketspezifischen Punktierungsmusters (27a, ..., 27m) aus dem Satz von vorherbestimmten paketspezifischen Punktierungsmustern (27a, ..., 27m),
bestimmen, auf der Basis des anderen paketspezifischen Punktierungsmusters (27a, ..., 27m), für jedes empfangene Codierer-Ausgangsbit in dem empfangenen Paket (11, 11a, 11b, 11c), des Faltungscodierers (21a, 21b, ..., 21n), der verwendet wurde, um das jeweilige Codierer-Ausgangsbit zu erhalten, und Verwenden einer Umkehrung des bestimmten Faltungscodierers (21a, 21b, ..., 21n) zum Decodieren des jeweiligen Codierer-Ausgangsbits, um das entsprechende Nutzlastbit zu erhalten, und
nach dem Decodieren aller empfangenen Codierer-Ausgangsbits des empfangenen Pakets (11, 11a, 11b, 11c) unter Verwendung des anderen paketspezifischen Punktierungsmusters (27a, ..., 27m), Durchführen einer Integritätsprüfung der erhaltenen Nutzlastbits, um zu bestimmen, ob das Paket (11, 11a, 11b, 11c) fehlerfrei empfangen wurde, und ob das andere paketspezifische Punktierungsmuster (27a, ..., 27m) an dem Sender (5) verwendet wurde, um die Codierer-Ausgangsbits für das empfangene Paket (11, 11a, 11b, 11c) zu wählen.

3. Verfahren nach Anspruch 1 oder 2, wobei das Verfahren im Fall eines Fehlschlags der Integritätsprüfung für wenigstens ein paketspezifisches Punktierungsmuster (27a, ..., 27m) und vorzugsweise alle paketspezifischen Punktierungsmuster (27a, ..., 27m) in dem Satz von vorherbestimmten paketspezifischen Mustern für das empfangene Paket (11, 11a, 11b, 11c) das Versuchen eines Decodierens des empfangenen Pakets (11, 11a, 11b, 11c) unter Verwendung einer Vorwärtsfehlerkorrektur umfasst.

4. Verfahren nach einem der vorhergehenden Ansprüche, wobei das Verfahren im Fall eines Fehlschlags der Integritätsprüfung für alle paketspezifischen Punktierungsmuster (27a, ..., 27m) in dem Satz von vorherbestimmten paketspezifischen Mustern für zwei oder mehr empfangene Pakete (11, 11a, 11b, 11c) das Kombinieren von wenigstens zwei der empfangenen Pakete (11, 11a, 11b, 11c) für eine Vorwärtsfehlerkorrektur umfasst.

5. Verfahren nach einem der vorhergehenden Ansprüche, wobei das Verfahren im Fall eines Bestehens der Integritätsprüfung das Bestimmen, dass die Nutzlast, die in den mehreren Paketen (11, 11a, 11b, 11c) codiert ist, fehlerfrei empfangen wurde, das Verwerfen jeglicher anderer Pakete (11, 11a, 11b, 11c) der mehreren Pakete (11, 11a, 11b, 11c), die bereits an dem Empfänger (9) empfangen wurden und die gleiche Nutzlast tragen, und das Verwerfen jeglicher anderer Pakete (11, 11a, 11b, 11c) der mehreren Pakete (11, 11a, 11b, 11c), die anschließend an dem Empfänger (9) empfangen werden und die gleiche Nutzlast tragen, umfasst.

6. Verfahren nach einem der vorhergehenden Ansprüche, wobei nach dem Erhalten eines entsprechenden Nutzlastbits von einem empfangenen Codierer-Ausgangsbit mit einer Umkehrung des bestimmten Faltungscodierers (21a, 21b, ..., 21n) das entsprechende Nutzlastbit mit den restlichen Faltungscodierern (21a, 21b, ..., 21 n) der mehreren unterschiedlichen Faltungscodierer (21a, 21b, ..., 21n) codiert wird, um einen Zustand (41) eines jeden der restlichen Faltungscodierer (21a, 21b, ..., 21 n) zu aktualisieren.

7. Verfahren nach einem der vorhergehenden Ansprüche, wobei jedes Paket (11, 11a, 11b, 11c) der mehreren Pakete (11, 11a, 11b, 11c) ferner wenigstens ein redundantes Bit aufweist, das an dem Sender (5) gemäß dem paketspezifischen Punktierungsmuster (27a, ..., 27m) aus den Codierer-Ausgangsbits gewählt wurde, wobei das eine oder die mehreren redundanten Bits eine Information tragen, die für wenigstens ein anderes Codierer-Ausgangsbit, das in dem Untersatz (25a, ..., 25m) von Codierer-Ausgangsbits, der für das jeweilige Paket gewählt wurde, enthalten ist, redundant ist,
wobei das empfangene Paket (11, 11a, 11b, 11c) wenigstens ein empfangenes redundantes Bit aufweist,
wobei nach dem Erhalten eines oder mehrerer Nutzlastbits, aus denen das wenigstens eine empfangene redundante Bit an dem Sender (5) als Teil der Encoder-Ausgangsbits erhalten wurde, das eine oder die mehreren erhaltenen Nutzlastbits an dem Empfänger (9) mit den jeweiligen Faltungscodierern (21a, 21b, ..., 21 n) codiert werden, um die Codierer-Ausgangsbits, die den redundanten Bits entsprechen, zu erhalten,
wobei in einem Fall, in dem das wenigstens eine empfangene redundante Bit nicht dem wenigstens einen redundanten Bit, das an dem Empfänger (9) von dem einen oder mehreren erhaltenen Nutzlastbits erhalten wurde, entspricht, bestimmt wird, dass das Paket (11, 11a, 11b, 11c) nicht fehlerfrei empfangen wurde und/oder das gewählte paketspezifische Punktierungsmuster (27a, ..., 27m) nicht an dem Sender (5) verwendet wurde, um die Codierer-Ausgangsbits für das empfangene Paket zu wählen.

8. Verfahren nach Anspruch 7, wobei jedes Paket (11, 11a, 11b, 11c) wenigstens N redundante Bits aufweist, wobei N größer oder gleich 5 und vorzugsweise größer oder gleich 7 ist,
wobei in einem Fall, in dem jedes der N empfangenen redundanten Bits dem jeweiligen redundanten Bit, das an dem Empfänger (9) von den decodierten Nutzlastbits erhalten wurde, entspricht, bestimmt wird, dass das gewählte paketspezifische Punktierungsmuster (27a, ..., 27m) an dem Sender (5) verwendet wurde, um die Codierer-Ausgangsbits für das empfangene Paket (11, 11a, 11b, 11c) zu wählen.

9. Verfahren nach einem der vorhergehenden Ansprüche, wobei jedes Paket (11, 11a, 11b, 11c) der mehreren Pakete (11, 11a, 11b, 11c) ferner wenigstens eines aus mehreren Header-Bits und mehreren Synchronisationsbits aufweist, wobei das Verfahren ferner die folgenden Schritte umfasst:
Bestimmen einer Bitfehlerrate des wenigstens einen aus mehreren Header-Bits und mehreren Synchronisationsbits des empfangenen Pakets, und
anhalten der Verarbeitung des empfangenen Pakets (11, 11a, 11b, 11c), wenn die bestimmte Bitfehlerrate einen Schwellenwert übersteigt.

10. Verfahren nach einem der vorhergehenden Ansprüche, wobei alle paketspezifischen Punktierungsmuster (27a, ..., 27m) so konfiguriert sind, dass alle nichtredundanten Codierer-Ausgangsbits, die in einem Paket (11, 11a, 11b, 11c) empfangen wurden, unter Verwendung der Umkehrung des gleichen Faltungscodierers (21a, 21b, ..., 21n) decodiert werden können, um die entsprechenden Nutzlastbits zu erhalten.

11. Empfänger (9) zum drahtlosen Empfangen einer drahtlosen Sendung, die mehreren Pakete (11, 11a, 11b, 11c) aufweist, wobei der Empfänger (9) so eingerichtet ist, dass er das Verfahren nach einem der vorhergehenden Ansprüche durchführt.

12. System, aufweisend einem Empfänger (9) nach Anspruch 11 und einen Sender (5),
wobei der Sensor (5) so eingerichtet ist, dass er eine Nutzlast, die mehrere Nutzlastbits aufweist, in mehreren Paketen (11, 11a, 11b, 11c) sendet, wobei jedes Paket (11, 11a, 11b, 11c) der mehreren Pakete (11, 11a, 11b, 11c) einen Untersatz von mehreren Codierer-Ausgangsbits aufweist,
wobei der Sender (5) so eingerichtet ist, dass er die Nutzlastbits mit mehreren unterschiedlichen Faltungscodierern (21a, 21b, ...,21n) codiert, um die mehreren Codierer-Ausgangsbits zu erhalten, den Untersatz für jedes Paket (11, 11a, 11b, 11c) gemäß einem paketspezifischen Punktierungsmuster (27a, ..., 27m) aus den mehreren Codierer-Ausgangsbits wählt, wobei das paketspezifische Punktierungsmuster (27a, ..., 27m) an dem Sender (5) aus einem Satz von vorherbestimmten paketspezifischen Punktierungsmustern (27a, ..., 27m) gewählt wird, und wobei die paketspezifischen Punktierungsmuster (27a, ..., 27m) so konfiguriert sind, dass jedes Paket (11, 11a, 11b, 11c) der mehreren Pakete (11, 11a, 11b, 11c) einzeln decodierbar ist, und die Pakete (11, 11a, 11b, 11c) sendet.

13. System nach Anspruch 12,
wobei die paketspezifischen Punktierungsmuster (27a, ..., 27m) so konfiguriert sind, dass jedes Paket (11, 11a, 11b, 11c) nur Codierer-Ausgangsbits, die unter Verwendung eines Faltungscodierers (21a, 21b, ..., 21n) der mehreren unterschiedlichen Faltungscodierer (21a, 21b, ..., 21 n) erhalten wurden, aufweist.

## Revendications

1. Procédé de décodage rapide d'une transmission sans fil comprenant des multiples paquets (11, 11a, 11b, 11c) pour obtenir une charge utile comprenant une pluralité de bits de charge utile au niveau d'un récepteur (9), dans lequel chaque paquet (11, 11a, 11b, 11c) des multiples paquets (11, 11a, 11b, 11c) comprend un sous-ensemble (25a, ..., 25m) d'une pluralité de bits de sortie d'encodeur, dans lequel la pluralité de bits de sortie d'encodeur a été obtenue au niveau d'un émetteur (5) en codant les bits de charge utile avec une pluralité d'encodeurs convolutifs (21a, 21b, ..., 21n) avec différents polynômes et dans lequel le sous-ensemble (25a,..., 25m) pour chaque paquet (11, 11a, 11b, 11c) a été sélectionné selon un modèle de perforation spécifique au paquet (27a, ..., 27m) parmi la pluralité de bits de sortie d'encodeur, dans lequel le modèle de perforation spécifique au paquet (27a, ..., 27m) est sélectionné au niveau de l'émetteur (5) parmi un ensemble de modèles de perforation spécifiques au paquet prédéterminés (27a, ..., 27m) et dans lequel chaque sous-ensemble (25a, ..., 25m) de la pluralité de bits de sortie d'encodeur sélectionnés pour un paquet (11, 11a, 11b, 11c) des multiples paquets (11, 11a, 11b, 11c) permet de décoder la totalité de la charge utile, le procédé comprenant les étapes suivantes:
la réception d'un paquet (11, 11a, 11b, 11c) des multiples paquets (11, 11a, 11b, 11c) au niveau du récepteur (9), le paquet (11, 11a, 11b, 11c) comprenant une pluralité de bits de sortie d'encodeur reçus,
la sélection d'un modèle de perforation spécifique au paquet (27a, ..., 27m) parmi l'ensemble de modèles de perforation spécifiques au paquet prédéterminés (27a, ..., 27m), **caractérisé en ce que**:
à partir du modèle de perforation spécifique au paquet sélectionné (27a, ..., 27m), pour chaque bit de sortie d'encodeur reçu dans le paquet reçu (11, 11a, 11b, 11c), la détermination de l'encodeur convolutif (21a, 21b, ..., 21n) qui aurait été utilisé pour obtenir le bit de sortie d'encodeur correspondant selon le modèle de perforation spécifique au paquet sélectionné (27a, ..., 27m) et l'utilisation d'un inverse d'encodeur convolutif déterminé (21a, 21b,..., 21n) pour décoder le bit de sortie d'encodeur respectif afin d'obtenir le bit de charge utile correspondant et
après le décodage de tous les bits de sortie d'encodeur reçus du paquet reçu, l'exécution d'un contrôle d'intégrité des bits de charge utile obtenus afin de déterminer si le paquet (11, 11a, 11b, 11c) a été reçu sans erreur et si le modèle de ponctuation spécifique au paquet sélectionné (27a, ..., 27m) a été utilisé au niveau de l'émetteur (5) pour sélectionner les bits de sortie d'encodeur pour le paquet reçu (11, 11a, 11b, 11c).

2. Procédé selon la revendication 1, dans lequel, en cas d'échec du contrôle d'intégrité, le procédé comprend en outre les étapes suivantes:
la sélection d'un autre modèle de perforation spécifique au paquet (27a, ..., 27m) parmi l'ensemble des modèles de perforation spécifiques au paquet prédéterminés (27a, ..., 27m),
sur la base de l'autre modèle de perforation spécifique au paquet (27a, ..., 27m), pour chaque bit de sortie d'encodeur reçu dans le paquet reçu (11, 11a, 11b, 11c), la détermination de l'encodeur convolutif (21a, 21b, ..., 21n) utilisé pour obtenir le bit de sortie d'encodeur respectif et l'utilisation d'un inverse de l'encodeur convolutif déterminé (21a, 21b, ..., 21n) pour décoder le bit de sortie d'encodeur respectif afin d'obtenir le bit de charge utile correspondant et
après le décodage de tous les bits de sortie d'encodeur reçus du paquet reçu (11, 11a, 11b, 11c), utilisant l'autre modèle de perforation spécifique au paquet (27a, ..., 27m), l'exécution d'un contrôle d'intégrité des bits de charge utile obtenus afin de déterminer si le paquet (11, 11a, 11b, 11c) a été reçu sans erreur et si l'autre modèle de perforation spécifique au paquet (27a, ..., 27m) a été utilisé au niveau de l'émetteur (5) pour sélectionner les bits de sortie d'encodeur pour le paquet reçu (11, 11a, 11b, 11c).

3. Procédé selon les revendications 1 ou 2, dans lequel, en cas d'échec du contrôle d'intégrité pour au moins un modèle de perforation spécifique au paquet (27a, ..., 27m) et de préférence pour tous les modèles de perforation spécifiques au paquet (27a, ..., 27m) dans l'ensemble des modèles prédéterminés spécifiques au paquet pour le paquet reçu (11, 11a, 11b, 11c), le procédé consiste à tenter de décoder le paquet reçu (11, 11a, 11b, 11c) en utilisant une correction d'erreurs anticipée.

4. Procédé selon une quelconque des revendications précédentes, dans lequel, en cas d'échec du contrôle d'intégrité pour tous les modèles de perforation spécifiques aux paquets (27a, ..., 27m) de l'ensemble des modèles spécifiques aux paquets prédéterminés pour deux paquets reçus ou plus (11, 11a, 11b, 11c), le procédé consiste à combiner au moins deux des paquets reçus (11, 11a, 11b, 11c) pour la correction d'erreurs anticipée.

5. Procédé selon une quelconque des revendications précédentes, dans lequel, en cas de réussite du contrôle d'intégrité, le procédé consiste à déterminer que la charge utile encodée dans la pluralité de paquets (11, 11a, 11b, 11c) a été reçue sans erreur, à rejeter tous les autres paquets (11, 11a, 11b, 11c) parmi les multiples paquets (11, 11a, 11b, 11c) déjà reçus par le récepteur (9) et transportant la même charge utile et rejeter tous les autres paquets (11, 11a, 11b, 11c) parmi les multiples paquets (11, 11a, 11b, 11c) reçus ultérieurement au niveau du récepteur (9) et transportant la même charge utile.

6. Procédé selon une quelconque des revendications précédentes, dans lequel, après l'obtention d'un bit de charge utile correspondant à partir d'un bit de sortie d'encodeur reçu avec un inverse de l'encodeur convolutif déterminé (21a, 21b, ..., 21n), le bit de charge utile correspondant est encodé avec les encodeurs convolutifs restants (21a, 21b, ..., 21n) de la pluralité d'encodeurs convolutifs différents (21a, 21b, ..., 21n) afin de mettre à jour un état (41) de chacun des encodeurs convolutifs restants (21a, 21b, ..., 21n).

7. Procédé selon une quelconque des revendications précédentes, dans lequel chaque paquet (11, l1a, 11b, l1c) des multiples paquets (11, l1a, 11b, l1c) comprend en outre au moins un bit redondant sélectionné au niveau de l'émetteur (5) parmi les bits de sortie d'encodeur selon le modèle de perforation spécifique au paquet (27a,..., 27m), dans lequel un ou plusieurs bits redondants transportent des informations redondantes par rapport à au moins un autre bit de sortie d'encodeur inclus dans le sous-ensemble (25a,..., 25m) des bits de sortie d'encodeur sélectionnés pour le paquet respectif,
dans lequel le paquet reçu (11, 11a, 11b, 11c) comprend au moins un bit redondant reçu,
dans lequel, après l'obtention d'un ou plusieurs bits de charge utile à partir desquels le au moins un bit redondant reçu a été obtenu au niveau de l'émetteur (5) en tant que partie des bits de sortie d'encodeur, un ou plusieurs bits de charge utile obtenus sont encodés à l'aide des encodeurs convolutifs respectifs (21a, 21b, ..., 21n) au niveau du récepteur (9) afin d'obtenir les bits de sortie d'encodeur correspondant aux bits redondants,
dans lequel au cas où un bit redondant reçu ne correspond pas à au moins un bit redondant obtenu au niveau du récepteur (9) parmi un ou plusieurs bits de charge utile obtenus, il est déterminé que le paquet (11, 11a, 11b, 11c) n'a pas été reçu sans erreur et/ou que le modèle de perforation spécifique au paquet sélectionné (27a, ..., 27m) n'a pas été utilisé au niveau de l'émetteur (5) pour sélectionner les bits de sortie d'encodeur pour le paquet reçu.

8. Procédé selon la revendication 7, dans lequel chaque paquet (11, 11a, 11b, 11c) comprend au moins N bits redondants, N étant supérieur ou égal à 5 et de préférence supérieur ou égal à 7,
dans lequel, au cas où chacun des N bits redondants reçus correspond au bit redondant respectif obtenu au niveau du récepteur (9) à partir des bits de charge utile décodés, il est déterminé que le modèle de perforation spécifique au paquet sélectionné (27a, ..., 27m) a été utilisé au niveau de l'émetteur (5) pour sélectionner les bits de sortie d'encodeur pour le paquet reçu (11, 11a, 11b, 11c).

9. Procédé selon une quelconque des revendications précédentes, dans lequel chaque paquet (11, l1a, 11b, l1c) des multiples paquets (11, l1a, 11b, l1c) comprend en outre au moins un d'une pluralité de bits d'en-tête et d'une pluralité de bits de synchronisation, le procédé comprenant en outre les étapes de:
détermination d'un taux d'erreur binaire d'au moins un d'une pluralité de bits d'en-tête et d'une pluralité de bits de synchronisation du paquet reçu et
arrêt du traitement du paquet reçu (11, 11a, 11b, 11c) si le taux d'erreur binaire déterminé dépasse un seuil.

10. Procédé selon une quelconque des revendications précédentes, dans lequel tous les modèles de perforation spécifiques aux paquets (27a, ..., 27m) sont configurés de sorte que tous les bits de sortie d'encodeur non redondants reçus dans un paquet (11, 11a, 11b, 11c) puissent être décodés à l'aide de l'inverse du même encodeur convolutif (21a, 21b, ..., 21n) pour obtenir les bits de charge utile correspondants.

11. Récepteur (9) pour la réception sans fil d'une transmission sans fil comprenant des multiples paquets (11, 11a, 11b, 11c), dans lequel le récepteur (9) est configuré pour exécuter le procédé selon une quelconque des revendications précédentes.

12. Système comprenant un récepteur (9) selon la revendication 11 et un émetteur (5),
dans lequel l'émetteur (5) est configuré pour transmettre une charge utile comprenant une pluralité de bits de charge utile dans des multiples paquets (11, 11a, 11b, 11c), chaque paquet (11, 11a, 11b, 11c) des multiples paquets (11, 11a, 11b, 11c) comprenant un sous-ensemble d'une pluralité de bits de sortie d'encodeur,
dans lequel l'émetteur (5) est configuré pour encoder les bits de charge utile avec une pluralité d'encodeurs convolutifs différents (21a, 21b, ..., 21n) afin d'obtenir la pluralité de bits de sortie d'encodeur et sélectionner le sous-ensemble pour chaque paquet (11, 11a, 11b, 11c) selon un modèle de perforation spécifique au paquet (27a, ..., 27m ) à partir de la pluralité des bits de sortie d'encodeur, dans lequel le modèle de perforation spécifique au paquet (27a, ..., 27m) est sélectionné au niveau de l'émetteur (5) à partir d'un ensemble de paquets prédéterminés de modèles de perforation spécifiques aux paquets (27a, ..., 27m) et dans lequel les modèles de perforation spécifiques aux paquets (27a, ..., 27m) sont configurés de sorte que chaque paquet (11, 11a, 11b, 11c) des multiples paquets (11, 11a, 11b, 11c) soit décodable individuellement et transmettent les paquets (11, l1a, l1b, l1c).

13. Système selon la revendication 12,
dans lequel les modèles de perforation spécifiques aux paquets (27a, ..., 27m) sont configurés de sorte que chaque paquet (11, 11a, 11b, 11c) ne comprenne que des bits de sortie d'encodeur obtenus à l'aide d'un encodeur convolutif (21a, 21b, ..., 21n) de la pluralité d'encodeurs convolutifs différents (21a, 21b, ..., 21n).
